# EUROPEAN PATENT APPLICATION

(11) **EP 4 703 887 A1**
(43) Date of publication of application: **04.03.2026**
(21) Application number: 25196317.9
(22) Date of filing: 18.08.2025
(51) Int. Cl.: G06F 11/10, G11C 29/04, G06F 11/1446, G06F 11/16

(54) **MEMORY CONTROLLER AND MCU CHIP**

(30) Priority: 29.08.2024 CN 202411205102
(71) Applicant: GigaDevice Semiconductor Inc., Haidian, Beijing (CN)
(72) Inventor: GAO, Yang, Beijing (CN)
(74) Representative: dompatent

(57) **Abstract**

A memory controller (MC) and a microcontroller unit (MCU) chip are disclosed. The MC is obtained by adding a smart load control (SLC) module to an MC architecture with an ECC logic module. When a CPU is reading contents from first memory, the ECC logic module can accurately identify soft failure locations and correct 1, 2 or more bit errors, and when errors exceeding the error correction ability of the ECC logic module, the SLC module can select a suitable error correction mode for handling the soft failures in the first memory based on conditions of different ECC errors and soft failure locations as well as on the system's error correction need. In this way, triggering a reset whenever there are errors exceeding the error correction ability of the ECC logic module, which necessitates interrupting the ongoing execution of a program, can be circumvented, and regardless of what soft errors have occurred, rapid soft error correction can be achieved with improved operating continuity of the system. Further, high operational reliability of the system is taken into account, and various reliability needs can be addressed.

## Description

### TECHNICAL FIELD

The present invention relates to the field of memory control, and particularly to a memory controller and a microcontroller unit (MCU) chip.

### BACKGROUND

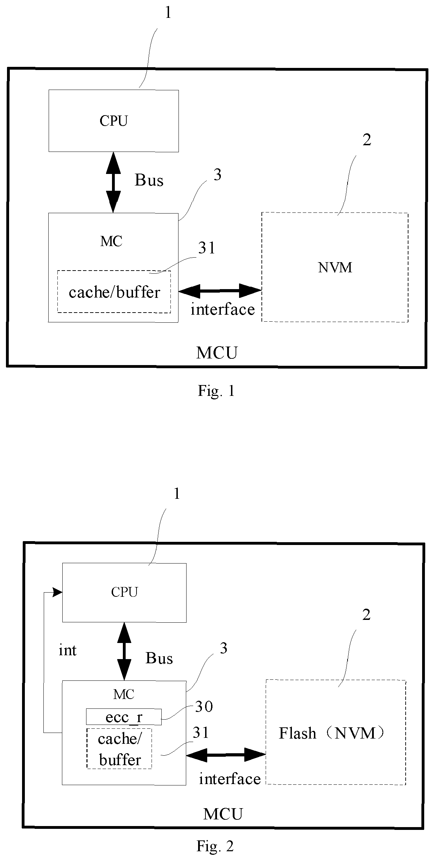

Referring to Fig. 1, in microcontroller unit (MCU) chips, various memory controllers (MCs) 3 are often used to manage reading and writing of on-chip and off-chip memory. Examples of on-chip memory include static random-access memory (SRAM, e.g., the buffer/cache 31 of Fig. 1), embedded flash (eFlash) memory, resistive random-access memory (RRAM), etc. On-chip memory, for example, the non-volatile memory (NVM) 2 of Fig. 1, may be integrated in the MCU chip, together with a central processing unit (CPU) 1, using embedded memory technology, or (in case of RRAM, SiP flash memory, etc.) using a system-in-package (SiP) or other packaging technique. Examples of off-chip memory (not shown) include NOR flash memory, NAND flash memory, dynamic random-access memory (DRAM), etc. Off-chip memory may be implemented outside the MCU chip, and connected thereto through traces on a printed circuit board (PCB).

As shown in Fig. 1, since the NVM 2 such as flash memory is typically read and written slower than operation of the CPU 1 in the MCU chip, the buffer/cache (consisting of either or both of a buffer and a cache and optionally implemented within the MC 3, or between the CPU and a bus matrix) 31 is typically introduced into the MCU chip. Upon a power-on reset (POR) or system reset of the MCU chip, contents (codes, instructions, data and the like necessary for operation) are copied from the NVM such as flash or other slower memory into the buffer/cache 31. After that, the CPU can directly run the contents in the buffer/cache 31 without any waiting time, instead of accessing the NVM for the contents. This reduces the number of times the NVM is read by the CPU, speeds up the overall operation of the system and improves its operating efficiency, thereby greatly enhancing the MCU's performance.

As intelligence grows in the alternative fuel vehicle and consumer industries, there has been an increasing demand on the market for MCU chips with higher performance and higher reliability. Moreover, the capacities of these cache and buffer implemented by SRAM is becoming increasingly larger, and they are increasingly affected by the surrounding environment, which leads to a higher soft-failure probability of associated MCs. For example, one type of soft failure is a bit, which becomes incorrect in an SRAM cache or an SRAM buffer, but remains correct in corresponding NVM.

A common method used in the art to overcome this problem is to introduce error checking and correction (ECC) logic, which can typically detect and correct a number of bit errors at a time. For example, the ECC logic may be able to detect and correct a single bit error and detect two or more bit errors (i.e., single-bit error-correction, double-bit error detection (SEC-DED)), or to detect and correct two bit errors and detect three or more bit errors (i.e., double-bit error-correction, three-bit error detection (SEC-TED)).

Fig. 2 shows an example in which the MC 3 is used to control flash memory, which may be implemented either within or outside the MCU chip. The MC 3 is connected to the CPU via an on-chip bus *int* in the MCU chip, and is also connected to the flash memory via a memory interface. The MC 3 includes a buffer and/or a cache (optionally implemented by SRAM) and an ECC logic module ecc_r. During a POR, system reset or when the CPU reads cache and a cache miss occurs, the MC 3 copies relevant contents from the flash memory into the buffer or cache. Each address of the buffer or cache stores an ECC checksum for corresponding content, and after the content is read by the CPU from the buffer or cache, the ECC logic module ecc_r, e.g., with SEC-DED capabilities, checks whether the ECC checksum for the content is correct or not in real time. Once any ECC checksum is found to be incorrect due to a soft failure, the MC 3 generates an interrupt signal to the CPU for processing.

This scheme can significantly improve reliability of the MCU system, but in the event of multiple bit errors (exceeding the maximum number of bit errors that the ecc_r module can handle each time), the SEC-DED capabilities of the ECC logic module ecc_r will not be able to correct the errors. In order to overcome this, conventional MCU systems usually have to cause a system reset to invalidate the contents currently cached in the buffer or cache and then trigger the MC to again copy the contents from the flash memory into the cache or buffer. The contents to be transferred tend to be large in quantity, and operation of the system has to be interrupted and resumed later. Consequently, a large amount of correct contents cached in the cache or buffer is unnecessarily transferred again from the flash memory, and operational continuity of the system is seriously affected, leading to a significant waste of time and dramatically degrading the system's overall performance.

### SUMMARY OF THE INVENTION

It is an object of the present invention to provide a memory controller, an ECC method and a chip, which are capable of rapidly correcting various soft failures and improving the system's operational continuity while ensuring its high operational reliability.

To this end, the present invention provides a memory controller (MC) coupled to a central processing unit (CPU), first memory and second memory. The first memory is associated with a higher soft-failure probability than the second memory. One of the first memory and the second memory is main memory, and the other is configured to back up at least a part of contents in the main memory. The MC comprises:
an error checking and correction (ECC) logic module, configured to, during reading of contents by the CPU from the first memory, perform an ECC on the contents from the first memory to detect and correct error contents from the first memory in real time, wherein in case of errors exceeding an error correction ability, a soft-failure induced ECC error occurs; and
a smart load controller (SLC) module, configured to select different error correction modes for handling the soft failures in the first memory based on conditions of different ECC errors obtained by the ECC logic module and soft failure locations, wherein the handling comprises overwriting and refreshing or invalidating the soft failure locations in the first memory,
wherein a required address range of different error correction modes varies in size.

With this arrangement, the MC can be obtained by adding the SLC module to an existing MC architecture with the ECC logic module. When the CPU is reading contents from first memory, the ECC logic module can accurately identify soft failure locations, and when there are errors exceeding the error correction ability of the ECC logic module, the SLC module can select, based on conditions of the ECC error and soft failure locations, as well as on the system's error correction need, a suitable error correction mode for handling the soft failures in the first memory. Such handling includes overwriting or invalidating the soft failure locations in the first memory. **In** this way, triggering a reset whenever there are errors exceeding the error correction ability of the ECC logic module, which necessitates interrupting the ongoing execution of a program, can be circumvented, and regardless of what soft failures have occurred, rapid soft failure correction can be achieved with improved operating continuity of the system. Further, high operational reliability of the system is taken into account, and various reliability needs can be addressed.

Optionally, a minimum range of the required address range may be an address of the soft failure location, and the maximum range of the required address range may be an entire address space of the first memory. With this arrangement, a reasonable address range can be configured for each selected error correction mode according to the actual need, allowing for rapid soft failure correction.

Optionally, the SLC module may be further configured to copy correct contents in the required address range of the selected error correction mode from the second memory into the first memory, to accomplish the overwriting and refreshing of the first memory. For example, only the soft failure locations, or a suitable address range (i.e., the address range of the selected error correction mode, which may be a row, a column, a block, etc.), or the entire address space, of the first memory may be overwritten and refreshed with the correct contents from the second memory.

Optionally, the MC, the first memory and the CPU may be integrated in a single chip, wherein the first memory is on-chip memory of the chip, and wherein the second memory is on-chip or off-chip memory of the chip and is non-volatile. With this arrangement, different chip architectures can be provided, which can address various product needs.

Optionally, the second memory may be the main memory and the first memory may be a cache that is read and written faster than the second memory, wherein the SLC module is further configured for at least one of:
(1) upon a power-on reset (POR) or a system reset, or when the CPU reads the first memory and a cache miss occurs, backing up corresponding contents in the second memory to the first memory and storing an ECC code corresponding to the backup contents in the first memory, wherein when the CPU is reading corresponding contents in the first memory, the ECC logic module performs an ECC on the contents read from the first memory by checking whether the corresponding ECC code is correct or not;
(2) when the first memory with automatic content reread capabilities, selecting a corresponding error correction mode and configuring the required address range of the corresponding error correction mode based on: a pre-configured error correction mode and the required address range thereof; or conditions of the ECC error and the soft failure locations, to invalidate contents in the required address range in the first memory based on the selected error correction mode, wherein the required address range contains the soft failure locations;
(3) when the first memory without automatic content reread capabilities, selecting a suitable error correction mode, based on conditions of the ECC error and the soft failure locations, to copy correct contents in the required address range of the selected error correction mode from the second memory into the first memory, thereby overwriting and refreshing the soft failure locations in the first memory, wherein the error correction modes comprises a precise mode, a partial refreshing mode, and a reset mode, wherein in the precise mode, the required address range is the soft failure locations in the first memory, wherein in the partial refreshing mode, the required address range is fixed, or configured in adaptation to the conditions of the ECC error and the soft failure locations, wherein in the reset mode, a system reset is triggered to enable the overwriting and refreshing of contents in the first memory, and wherein in the reset mode, the required address range is larger than a maximum range of the required address range in the partial refreshing mode and smaller than or as large as an entire address space of the first memory. With this arrangement, for the cache (i.e., the first memory) without automatic reread capabilities, a suitable error correction mode can be selected according to the actual need, in which contents in an address range in the cache (i.e., the first memory) of the selected error correction mode can be overwritten and refreshed with correct contents, achieving both high overwriting efficiency and low time cost.

Optionally, the first memory may comprise static random-access memory (SRAM). With this arrangement, the present invention can be used to address soft failures in a cache implemented by conventional SRAM.

Optionally, the first memory may be an SRAM buffer or an SRAM cache for backing up at least part of contents in the second memory. Alternatively, the first memory may comprise: a buffer for backing up part of contents in the main memory; and a cache for backing up contents outside an address range of the buffer. With this arrangement, at least one of a buffer and a cache is introduced, which can speed up overall operation of the system. Moreover, soft failures (and hence contents containing them) in the buffer and cache can be corrected exactly and reasonably based on conditions of the soft failures.

Optionally, the SLC module may be further configured for at least one of:
(1) in case of the first memory comprising the cache and the buffer, firstly determining which one of the cache and the buffer contains the soft failure locations;
(2) in case of the soft failure locations being in the cache, selecting a suitable error correction modes and configuring the required address range of the error correction mode based on: a pre-configured error correction mode and the required address range thereof; or conditions of the ECC error and the soft failure locations, to invalidate contents in the required address range in the cache, wherein the required address range contains the soft failure locations, and wherein the invalidated required address range is: at least one cache line containing the soft failure locations; or at least one cache set containing the soft failure locations; or at least one cache way containing the soft failure locations; or an entire cache;
(3) in case of the soft failure locations being in the buffer, selecting a suitable error correction mode based on the conditions of the ECC error and the soft failure locations, to copy correct contents in the required address range of the selected error correction mode from the second memory into the buffer, thereby overwriting and refreshing the soft failure locations in the buffer, wherein the selected error correction modes comprises a precise mode, a partial refreshing mode and a reset mode, wherein in the precise mode, the required address range is the soft failure locations in the buffer, wherein in the partial refreshing mode, the required address range is at least one of: a row in the buffer, that contains at least the soft failure locations, a column in the buffer, that contains at least the soft failure locations; a sector in the buffer, that contains at least the soft failure locations; a page in the buffer, that contains at least the soft failure locations; a cluster in the buffer, that contains at least the soft failure locations; and a block in the buffer, that contains at least the soft failure locations, and wherein in the reset mode, a system reset is triggered to enable the overwriting and refreshing of contents in the buffer, and wherein the required address range of the reset mode is larger than a maximum range of the required address range in the partial refreshing mode and smaller than or as large as the entire buffer.

With this arrangement, when the soft failures occur in the buffer, a suitable error correction mode can be selected, in which depending on the actual circumstances, contents at exact locations or in a small address range, a large address range or the entire address space of the buffer can be overwritten and refreshed with correct contents from the second memory, achieving both high overwriting efficiency and low time cost. **In** contrast, in the prior art, when too many bit errors that exceed the error correction ability of the ECC function occur in the buffer, a large amount of correct content must be re-copied to overwrite the entire address space of the buffer, leading to significant time consumption.

Optionally, when the memory controller is coupled to the cache, the SLC module may further comprise a cache controller for accomplishing the invalidation of the contents in the cache and, wherein the cache controller is configured to accomplish the invalidation of corresponding contents in the cache, and wherein when the CPU or another master device unit reads the cache through the cache controller and a cache miss occurs, the cache controller is configured to automatically reread corresponding correct contents from the second memory and replenishing the correct contents into the cache. With this arrangement, contents in the cache can be automatically reread by using the cache controller, allowing the execution of an interrupted program to be resumed after a short time.

Optionally, the first memory may be the main memory and may be non-volatile, and the second memory may be configured to back up at least part of contents in the main memory, wherein the first memory is read and written faster than the second memory, and wherein the SLC module is further configured for at least one of:
(1) upon a POR or a system reset, backing up contents in the first memory to the second memory and storing an ECC code corresponding to the backup contents in the second memory and/or the first memory, wherein when the CPU is reading contents in the first memory, the ECC logic module is configured to perform ECC on the contents read from the first memory by checking whether the corresponding ECC code is correct or not;
(2) selecting a suitable error correction mode based on conditions of an ECC error and soft failure locations to copy correct contents in the required address range of the selected error correction mode from the second memory into the first memory, thereby overwriting and refreshing the soft failure locations in the first memory, wherein the error correction modes comprises a precise mode, a partial refreshing mode and a reset mode, wherein in the precise mode, the required address range is the soft failure locations in the first memory, wherein in the partial refreshing mode, the required address range is fixed or configured in adaptation to the conditions of the ECC error and the soft failure locations, wherein in the reset mode, a system reset is triggered to enable the overwriting and refreshing of contents in the first memory, and wherein the required address range of the reset mode is larger than a maximum range of the required address range in the partial refreshing mode and smaller than or as large as an entire address space of the first memory.

With this arrangement, when soft failures occur in the main memory (i.e., the first memory), a suitable error correction mode can be selected according to a need of the system for error correction, in which correct backup contents in a required address range in the cache (i.e., the second memory) can be read and written into the main memory (i.e., the first memory) to overwrite and refresh (or repair) contents in the main memory (i.e., the first memory), which contain the soft failures.

Optionally, the first memory may include at least one of ferroelectric random-access memory (FRAM), resistive random-access memory (RRAM), magnetoresistive random-access memory (MRAM) and phase-change random-access memory (PRAM). With this arrangement, the present invention can be used in MCU chip architectures employing recent main memory such as FRAM, RRAM, MRAM and PRAM to address soft failures in the recent main memory such as FRAM, RRAM, MRAM and PRAM. This allows the recent main memory such as FRAM, RRAM, MRAM and PRAM to fully play its role when used as a cache, for example, in significantly speeding up reading of contents, reducing the number of times of CPU access to the second memory, reducing power consumption, and so forth.

Optionally, the SLC module may be further configured to determine whether an accumulated ECC error count and/or a bit error count exceeds a preset threshold and, if so, the reset mode is selected, or otherwise the precise mode or the partial refreshing mode is selected. With this arrangement, only when too many soft failures occur, which may degrade the system's reliability, the reset mode is activated to address the soft failures. In contrast, in the prior art, once there are soft bit errors exceeding the error correction ability of the ECC function, all contents in the first memory must be overwritten, leading to significant time consumption and operation of the system being interrupted due to a reset.

Optionally, the SLC module may be further configured, when the selected error correction mode is the reset mode or the partial refreshing mode, to configure the required address range of the selected error correction mode by configuring a start address and an end address of an address range of the first memory to be overwritten and refreshed based on requirements. With this arrangement, in the reset or partial refreshing mode, the associated address range to be overwritten may be flexibly configured depending on the actual circumstances and need.

Optionally, the SLC module may be further configured to, after the overwriting and refreshing of the first memory is completed, cause the CPU to reread corresponding contents from the first memory and to cause the ECC logic module to perform ECC on the contents reread by the CPU. With this arrangement, the system will resume its operation only when correctness of the updated contents has been confirmed, ensuring reliable subsequent operation of the system.

Optionally, the MC may further comprise at least one of:
an interrupt register, configured to interrupt the CPU in response to an occurrence of a soft-failure induced ECC error;
an address record logic register, configured to record an ECC error count, a bit error count and addresses of soft failure locations in real time depending on an ECC conducted by the ECC logic module;
an SLC enable register, configured to activate the SLC module once the bit error count in the address record logic register exceeds the error correction ability of the ECC logic module;
a mode select register, configured to pre-configure or pre-select a suitable error correction mode for the SLC module, based on conditions of different ECC errors and soft failure locations, such that the SLC module handles the soft failures in the first memory using corresponding error correction mode according to conditions of an ECC error and soft failure locations; and
an address configuration register, configured for writing therein of a start address and an end address of the first memory that are to be overwritten and refreshed or invalidated in the error correction mode based on relevant information recorded in the address record logic register and a system need for error correction.

With this arrangement, the MC can perform, by virtue of the above registers, the functions of ECC logic, ecc_error interrupts, ecc_error address record logic, SLC activation, recording of start and end addresses, error correction mode selection, etc. Depending on required functionality, the registers may be only reset by a POR or similar operation.

On the basis of the same inventive concept, the present invention also provides an MCU chip comprising: a CPU, first memory and the MC of the present invention as defined above, which are integrated in a single chip package, a second memory is disposed inside or outside the MCU chip and is coupled to the memory controller.

The first memory is associated with a higher soft-failure probability than the second memory. One of the first memory and the second memory being main memory, and the other is configured to back up at least part of contents in the main memory under the control of the memory controller.

The CPU is adapted at least to read contents from the first memory.

The MC is configured to: control read operations of the CPU on the first memory and the second memory; during reading of contents from the first memory, perform an error checking and correction (ECC) on corresponding contents from the first memory to detect and correct of error contents from the first memory in real time; when the errors exceeds an error correction ability, generate a soft-failure induced ECC error; and select a corresponding error correction mode for handling the soft failures in the first memory in adaption to conditions of different ECC errors and the soft failure locations.

With this arrangement, the present invention provides a new MCU chip architecture incorporating the MC of the present invention, which can accurately identify soft failure locations in the first memory, exactly reread correct contents corresponding to the soft failure locations from the second memory and rapidly overwrite and refresh the soft failure locations in the first memory with the correct contents. Therefore, in addition to high reliability, rapid error correction and continued operation of the system can be achieved, and various reliability needs can be addressed.

### BRIEF DESCRIPTION OF THE DRAWINGS

Those of ordinary skill in the art would appreciate that the following drawings are presented to enable a better understanding of the present invention and do not limit the scope thereof in any sense, in which:
Fig. 1 depicts a schematic architecture diagram of a conventional MCU chip, into which a buffer/cache is introduced;
Fig. 2 depicts a schematic architecture diagram of a conventional MCU chip, into which ECC logic is introduced;
Fig. 3 depicts an exemplary schematic architecture diagram of a memory controller (MC) and an MCU chip incorporating the MC according to a first embodiment of the present invention;
Figs. 4A and 4B schematically illustrate two exemplary mappings between first memory and second memory in the architecture of the MC according to the first embodiment of the present invention;
Fig. 5 depicts another exemplary schematic architecture diagram of the MC and the MCU chip incorporating the MC according to the first embodiment of the present invention;
Fig. 6 is a schematic flowchart of an example process of addressing soft failures in the first memory by the MC according to the first embodiment of the present invention;
Fig. 7 depicts an exemplary schematic architecture diagram of an MC and an MCU chip incorporating the MC according to a second embodiment of the present invention;
Fig. 8 depicts another exemplary schematic architecture diagram of the MC and the MCU chip incorporating the MC according to the second embodiment of the present invention; and
Fig. 9 is a schematic flowchart of an example process of addressing soft failures in first memory by the MC according to the second embodiment of the present invention.

### DETAILED DESCRIPTION

The following description sets forth numerous specific details in order to provide a more thorough understanding of the present invention. However, it will be apparent to those skilled in the art that the present invention can be practiced without one or more of these specific details. In other instances, well-known technical features have not been described in order to avoid unnecessary obscuring of the invention. It is understood that the invention may be embodied in many different forms and should not be construed as being limited to the embodiments set forth below. Rather, these embodiments are provided so that this disclosure is thorough and conveys the scope of the invention to those skilled in the art. In the drawings, same reference numerals refer to same elements throughout. It will be understood that when an element is referred to as being "connected to" or "coupled to" another element, it can be directly connected or coupled to the other element, or intervening elements may also be present. In contrast, when an element is referred to as being "directly connected to" another element, there are no intervening elements. As used herein, the singular forms "a", "an" and "the" are intended to include the plural forms as well, unless the context clearly indicates otherwise. It will be further understood that the term "comprising" specifies the presence of stated features, steps, operations, elements, and/or components, but do not preclude the presence or addition of one or more other features, steps, operations, elements, components, and/or groups thereof. As used herein, the term "and/or" includes any and all combinations of the associated listed items.

The present invention will be described in greater detail below with reference to the accompanying drawings, which illustrate specific embodiments thereof. From the following description, advantages and features of the invention will become apparent. Note that the figures are provided in a very simplified form not necessarily drawn to exact scale for the only purpose of helping to explain the disclosed embodiments in a more convenient and clearer way.

### Embodiment 1

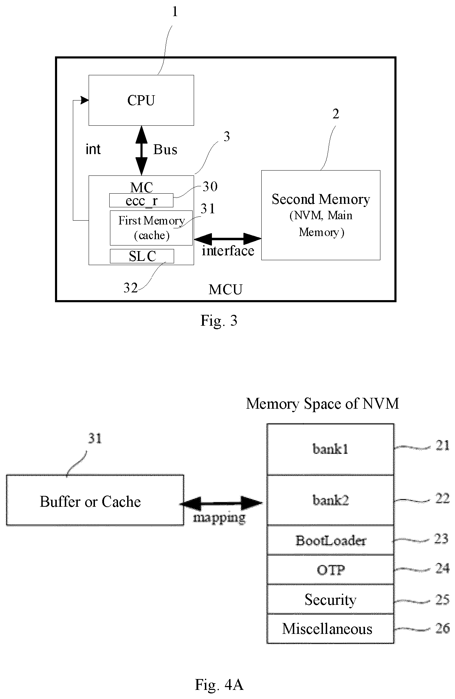

Referring to Fig. 3, a memory controller (abbreviated as "MC" hereinafter) 3 according to a first embodiment of the present invention is coupled to a central processing unit ("CPU") 1, first memory (a buffer/cache) 31 and second memory 2.

The second memory 2 is a main memory and is an non-volatile memory ("NVM") for storing various types of content (including program codes, instructions, data, etc.) for running and use by the CPU 1.

The NVM 2 may be physically implemented as on-chip memory by embedded memory (not shown), such as embedded flash (eFlash) memory or resistive random-access memory (RRAM). The NVM 2 may be incorporated in the MCU chip by being fabricated in a single die together with the MC 3 and the CPU 1. Alternatively, The NVM 2 may be incorporated in the MCU chip by being fabricated in a memory die (e.g., a flash or other memory die), which is packaged together with dies of the CPU 1 and the MC 3 within a single package (i.e., in the form of a system-in-package (SiP)), as shown in Fig. 3. In these cases, the NVM 2, the MC 3 and the CPU 1 may be considered as being integrated in a single chip package.

Alternatively, the NVM 2 may be physically implemented as off-chip memory, such as flash memory or dynamic random-access memory (DRAM), which may be disposed outside, and connected via traces on a printed circuit board (PCB) to, the MCU chip. In this case, the MC 3 and the CPU 1 are integrated within the MCU chip, while the NVM 2 is disposed outside the MCU chip. Moreover, the MC 3 serves as an extra memory controller (EXMC) module for controlling the external memory (i.e., the NVM 2).

The first memory 31 may be a cache arranged between the CPU 1 and the NVM 2, which is used to back up at least a part of contents in the second memory 2. Typically, the first memory 31 has much smaller capacity, but a much faster exchange rate, than the main memory (i.e., the NVM 2). The first memory 31 is provided as a cache mainly to address inconsistency in speed between operation of the CPU 1 and reading and writing of the main memory (i.e., the NVM 2).

The first memory 31 may be physically implemented as on-chip memory (built in the MCU chip), and may be logically arranged within the MC 3, as shown in Fig. 3. Alternatively, the first memory 31 may be logically arranged outside the MC 3. The first memory 31 may be provided by one or more memory blocks within the MCU chip. Compared with the NVM 2, the first memory 31 can be read and written at a higher speed, but is associated with a higher probability of soft failure. For example, the first memory 31 may include static random-access memory (SRAM) or the like.

SRAM is a type of memory that allows static access and stores data in transistors without needing to be refreshed. It has the advantages of less power consumption, high speed, no need to be refreshed in cooperation with the main memory and the ability to improve overall operating efficiency.

As an example, referring to Fig. 4A, the NVM 2 includes a first main bank (bank1) 21, a second main bank (bank2) 22, a bootloader bank 23, a one-time programming (OTP) code bank 24, a security code bank 25 and a miscellaneous bank 26. The first main bank 21 and the second main bank 22 are configured to store different main programs necessary for operation of the system, or separate replicas of the same main program necessary for operation of the system, each serving as a backup of the other. The bootloader bank 23 is configured to store bootloader code, and the OTP code bank 24 is configured to store OTP code. The security code bank 25 is configured to store security code, and the miscellaneous bank 26 is configured to store other contents than the above (data, other codes, etc.). The contents stored in the NVM 2 may be executed by the CPU to perform special functions such as system initialization, configuration of information (or parameters), security protection and so forth. Each of the first main bank 21 and the second main bank 22 has larger capacity than the bootloader bank 23, the OTP code bank 24, the security code bank 25 and the miscellaneous bank 26.

The first memory 31 may be a buffer implemented by one or more SRAM blocks in the MCU chip, which provides mirrored buffering and typically has a smaller capacity than the NVM 2. In response to a POR or system reset of the MCU chip, the MC 3 is able to copy (or back up) contents necessary for execution of programs in the NVM 2 (including codes and the like) into the buffer (i.e., the first memory 31) at a one-to-one ratio. During subsequent operation of the system, in response to a need of the CPU 1 for reading desired contents from the NVM 2, the MC 3 can convert logical addresses of the desired contents in the NVM 2 into actual physical addresses in the buffer (i.e., the first memory 31), making them directly addressable (e.g., bytewise) in the buffer. Thus, the desired contents in the NVM 2 can be read from the buffer and executed. In this way, the CPU 1 can run the contents that have been copied into the buffer directly in the buffer without any waiting time, and throughout this process, a memory interface between the MC 3 and the NVM 2 does not need to function. This reduces the number of times the NVM 2 is read, thereby significantly improving the system's operating efficiency and speeding up its operation.

As an example, if the buffer (i.e., the first memory 31) has a physical bit-width of 32 bits, since the logical address read by CPU 1 is byte-addressed, then MC 3 can convert the logical address of NVW 2 into the actual physical address of the buffer (i.e., the first memory 31) by dividing it by 4. As another example, if the buffer (i.e., the first memory 31) has a physical bit-width of 64 bits, since the logical address read by CPU 1 is byte-addressed, then MC 3 can convert the logical address of NVW 2 into the actual physical address of the buffer (i.e., the first memory 31) by dividing it by 8.

Further, in Embodiment 1, the MC 3 additionally includes error checking and correction (ECC) logic. If the contents that the CPU desires to read is in the format of "32-bit payload + 7-bit ECC code", then the first memory 31 (more precisely, physical SRAM IP) will have a bit-width of 39 bits. If the contents that the CPU desires to read is in the format of "64-bit payload + 8-bit ECC code", then the first memory 31 (more precisely, the physical SRAM IP) will have a bit-width of 72 bits. Since SRAM can be read very fast, the first memory 31 in the MC 3 can also be read very fast, speeding up the system's overall operation.

In this architecture, a sub-range of a logical address range of the NVM 2 is allocated for reading of the buffer (i.e., the first memory 31) by the CPU (logical addresses in this sub-range are mapped by the MC 3 to the buffer, rather than to the NVM 2). The CPU 1 cannot directly access contents of the NVM overwritten by the sub-range logical address allocated for reading of the buffer (i.e., the first memory 31) by the CPU, and these contents can be directly accessed in the buffer.

In another example, referring to Fig. 4A, the NVM 2 includes a first main bank 21, a second main bank 22, a bootloader bank 23, an OTP code bank 24, a security code bank 25 and a miscellaneous bank 26. The first memory 31 is a cache implemented by one or more SRAM blocks in the MCU chip, which provides caching. In the event of a POR or system reset of the MCU chip, or when the CPU 1 reads the cache and a cache miss occurs, the MC 3 can copy (or back up) contents (including codes and the like) necessary for execution of programs in the NVM 2 and adjacent contents into the cache. During subsequent operation of the system, when the CPU 1 needs to read desired contents from the NVM 2, the MC 3 can convert their logical addresses in the NVM 2 into actual physical addresses in the cache (i.e., first memory 31), to directly address (e.g., addressing by cache line) the cache. Thus, the desired contents stored at the logical addresses can be read from the cache and executed. In this way, the CPU 1 can run the contents directly in the cache, that have been copied into the cache, without any waiting time, and throughout this process, a memory interface between the MC 3 and the NVM 2 does not need to function. This reduces the number of times the NVM 2 is read, thereby significantly improving the system's operating efficiency and speeding up its operation.

The cache typically has a smaller capacity than the NVM 2 and the smallest unit of the cached content is a cache line. Each cache line has the same capacity as a single block in the NVM 2. Contents from the NVM 2 are backed up to the cache in unit of cache line. The cache may also be structured and organized into sets and ways, and cache lines in each single set have the same set index. In case of a set-associative cache, the cache is divided into cache blocks of the same size, each cache block forms a way, and a number of ways correspond to a single set.

If the cache is structured into S sets each with E cache lines and each cache line stores *B* bytes of backup content and has an m-bit address, *S* and *B* further divide the m-bit address into three parts: a t-bit tag; an s-bit set index and a b-bit block offset, in this way, the structure of the cache can be described by the quadruple (S, E, B, m). Depending on the line count E of each set, the cache can be categorized into one of the following classes: (1) directly mapped, where E=1, i.e., each set contains only one line; (2) fully associative, where E is equal to the total number of cache lines in the cache; and (3) set-associative, where E is greater than 1 and smaller than the total number of cache lines in the cache.

If the CPU 1 finds contents that it desires in the cache, this is called a cache hit. If the contents that the CPU 1 desires are not present in the cache (this is called a cache miss), the CPU 1 may then access the NVM 2.

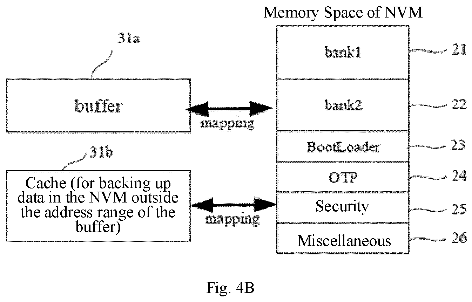

In yet another example, referring to Fig. 4B, the NVM 2 includes a first main bank 21, a second main bank 22, a bootloader bank 23, an OTP code bank 24, a security code bank 25 and a miscellaneous bank 26. The first memory 31 includes a buffer 31a implemented by one or more SRAM blocks within the MCU chip and a cache 31b implemented by one or more SRAM blocks within the MCU chip. The buffer 31a is configured to back up some of contents in the NVM 2 necessary for execution of associated programs at a one-to-one ratio, and the cache 31b is configured to back up some or all of contents in the NVM 2 necessary for operation of associated programs outside an address range of the buffer 31a. For example, the buffer 31a is configured to back up contents in the bootloader bank 23, the OTP code bank 24 and the security code bank 25 of the NVM 2 at a one-to-one ratio, while the cache 31b is configured to back up contents in the first main bank 21 and the second main bank 22 of the NVM 2 at a one-to-one ratio, or to back up contents in the first main bank 21, the second main bank 22 and the miscellaneous bank 26 of the NVM 2 at a one-to-one ratio. When a POR or system reset of the MCU chip or the CPU 1 reads the cache and a cache miss occurs, the MC 3 is able to copy some of contents (including codes and the like) in the NVM 2 necessary for operation of associated programs at a one-to-one ratio into the buffer 31a and to copy desired contents outside the address range of the buffer 31a into the cache 31b. During subsequent operation of the system, when the CPU 1 needs to read desired contents from the NVM 2, the MC 3 can convert their logical addresses in the NVM 2 into actual physical addresses in the buffer 31a or the cache 31b, making them directly addressable in the buffer 31a or the cache 31b. Thus, the desired contents stored at the logical addresses can be read from the buffer 31a or the cache 31b and executed. In this way, the CPU 1 can run the contents that have been copied into the buffer 31a or the cache 31b directly in the buffer 31a or the cache 31b without any waiting time, and throughout this process, the memory interface between the MC 3 and the NVM 2 does not need to function. This reduces the number of times the NVM 2 is read, thereby significantly improving the system's operating efficiency and speeding up its operation.

Referring to Fig. 3, in Embodiment 1, the MC 3 includes an ECC logic module (ecc_r) 30 and a smart load controller (SLC) module 32.

The ECC logic module 30 may be implemented with any suitable architecture design known in the art and configured to perform ECC on contents in the first memory 31 being read by the CPU 1 to detect and correct, in real time, possible errors in the contents in the first memory 31. If there are errors exceeding the error correction ability of the ECC logic module 30, a soft-failure induced ECC error will occur.

In Embodiment 1, During a POR/system reset, or when the CPU 1 reads the cache and the cache miss occurs, the SLC module 32 in the MC 3 may copy the desired contents from the NVM 2 (i.e., the main memory) into the first memory 31 (i.e., the cache), and during the copying process, the ECC logic module 30 may generate one (i.e., 1-bit) or more (e.g., 2-bit, 3-bit, etc.) check bits for each copied segment of original content according to a specific encoding rule (which specifies a calculating operation on the original contents) as an ECC code (or checksum), the ECC code is then stored, together with the corresponding content segment, at a corresponding address in the first memory 31. The locations of the check bits are carefully selected to allow one or more detected bit errors to be located and corrected. Therefore, the ECC codes can be used not only to detect an error but also to indicate the specific location of the error. Each address in the first memory 31 stores the corresponding content along with the ECC checksum for that content. Therefore, when CPU 1 reads the content from the first memory 31 (i.e., the cache) based on the address, the ECC logic module 30 is provided with the basis for performing ECC error detection and correction on the content read from the first memory 31.

Typically, the error correction ability of the ECC logic module 30 ranges from one 1 bit to a few bits. For example, in order to detect 8 bits of the original contents, the addition of 5 ECC check bits may be required; in order to detect 16 bits of the original contents, the addition of 6 ECC check bits may be required; ...; in order to detect 32 bits of the original contents, the addition of 7 ECC check bits may be required; and in order to detect 64 bits of the original contents, the addition of 8 ECC check bits may be required.

As an example, when the CPU 1 reads desired contents from the first memory 31(i.e., the cache), the ECC logic module 30 in the memory controller (MC) may utilize a single-bit error-correction, double-bit error detection (SEC-DED) scheme to check, in real time, whether corresponding ECC codes (7-bit, 8-bit, etc.) of the contents read by the CPU 1 (i.e., content segments stored at corresponding addresses in the first memory 31, which may be 32-bit, 64-bit or other segments) are correct or not. That is, the ECC logic module can detect and correct a single bit error and detect two or more bit errors, in each content segment read by the CPU 1. When there are errors exceeding the error correction ability of the ECC logic module 30 (i.e., there are multiple bit errors in a content segment read from the first memory 31 by the CPU 1, which cannot be corrected by the ECC logic module 30), a soft-failure induced ECC error ecc_error will occur, and an interrupt signal *int* will be responsively generated to the CPU 1 for processing (for interrupting the CPU 1).

In other examples of Embodiment 1, the ECC logic module 30 may also utilize a double-bit error-correction, three-bit error detection (SEC-TED) scheme to check, in real time, whether corresponding ECC codes of contents read by the CPU 1 from the first memory 31 are connect or not. In these cases, the ECC logic module can detect and correct two bit errors and detect three or more bit errors in each content segment read by the CPU 1.

Depending on conditions of different ECC errors that occurs in the ECC logic module 31 and soft failure locations, the SLC module 32 is configured to utilize different error correction modes to handle the soft failures in the first memory 31. Such handling may include overwriting and refreshing or invalidating the locations of the soft failures in the first memory 31, and each of the error correction mode may be associated with an address range of a different size.

In different error correction modes, the minimum range of the required address range is the address of the soft failure location, while the maximum range is the entire address space of the first memory 31. For example, with correct contents from the NVM 2, only the soft failure locations in the first memory 31, or a suitably-sized address range of the first memory 31 (i.e., part of the address space), which contains the soft failure locations, or the entire address space of the first memory, may be overwritten. Alternatively, contents in a suitably-sized address range of the first memory may be (partially or entirely) invalidated. In this way, in different soft failure conditions, rapid soft failure correction can be achieved, improving the system's operational continuity while ensuring its high operational reliability. Thus, various reliability needs can be addressed.

Optionally, the required address ranges of the error correction modes may have pre-configured sizes, or may have sizes temporarily configured in adaptation to the actual circumstances. Alternatively, the MC 3 may allocate pre-configured address ranges for some of the error correction modes of the SLC module 32, and may provide the remaining error correction modes with address configuration registers, and start and end addresses and the like are allowed to be written in address configuration register, thereby enabling address ranges for these error correction modes to be temporarily configured as required by the actual circumstances.

Additionally, the SLC module 32 may be able to copy correct contents from the required address range of the error correction mode (SLC modes) from the NVM 2 into the first memory 31, and thereby overwrite and refresh the first memory 31.

In other words, in Embodiment 1, if there are too many soft failures in contents in the first memory 31 that cannot be corrected by the ECC logic module 30, the SLC module 32 is able to select a suitable error correction mode based on the ECC error conditions and on the soft failure locations, to invalidate (in case of a cache) erroneous contents in a suitable range of the first memory 31, or to overwrite and refresh (in case of a buffer) the erroneous contents with correct contents, thereby eliminating the soft failures in the first memory 31. This circumvents updating all cached contents in the first memory 31 by a reset in all soft failure scenarios, which would take a lot of time. Moreover, continuous operation of the system can be ensured, and various reliability needs can be addressed.

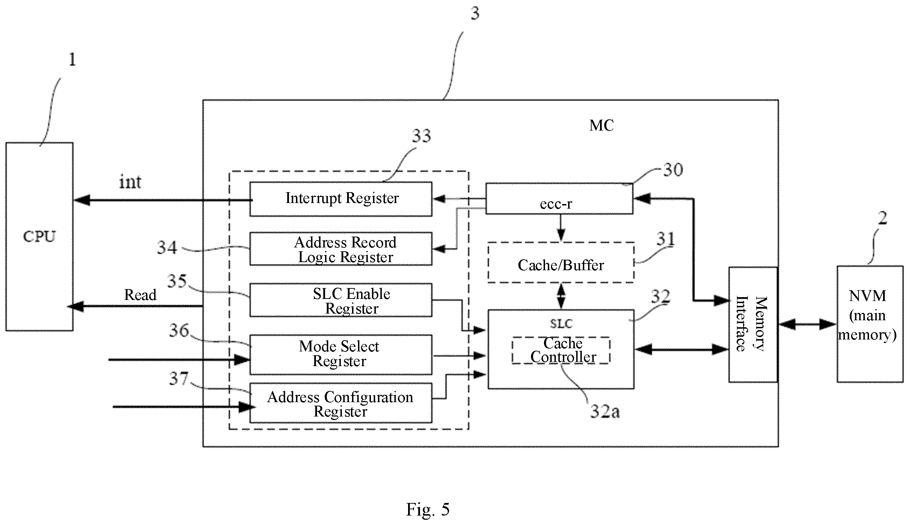

With combined reference to Figs. 4A, 4B and 5, in Embodiment 1, the SLC module 32 is also configured to:
(1) during a POR or system reset, or when s of reading the CPU 1 reads the cache 31b and a cache miss occurs, back up desired contents in the NVM 2 to the first memory 31 and store ECC codes of the backup contents in the first memory 31, wherein the ECC codes stored at addresses in the first memory 31 are optionally generated by the ECC logic module 30 based on original contents stored at corresponding logical addresses in the NVM 2;
(2) in case of the first memory 31 having automatic content reread capabilities (e.g., a cache implemented by SRAM), selecting a corresponding error correction mode and configuring a required address range of the corresponding error correction mode based on: a pre-configured error correction mode and a required address range thereof; or conditions of an ECC error and soft failure locations, to invalidate contents in the required address range in the first memory 31 based on the selected error correction mode, wherein the required address contains the soft failure locations. In this way, when soft failures occur in the cache with automatic content reread capabilities (i.e., the first memory 31), contents in a suitable range in the cache (which is selected so that the contents contain the errors) can be invalidated, and when the CPU 1 subsequently again tries to read an address containing the soft failure locations, correct contents will be automatically read from the main memory (i.e., the NVM 2) and replenished into the cache (i.e., the first memory 31), allowing the interrupted program to resume execution after a short time;
(3) in case of the first memory 31 not having automatic content reread capabilities, select a suitable error correction mode according to the ECC error conditions and the required soft failure locations, to copy correct contents in a required address range of the selected error correction mode from the NVM 2 into the first memory 31 to overwrite and refresh the soft failure locations in the first memory 31. In this case, error correction mode options may include a precise mode, a partial refreshing mode and a reset mode. In the precise mode, the required address range consists of only the soft failure locations in the first memory. In the partial refreshing mode, the required address range is fixed, or is configured in adaptation to the ECC error conditions and the soft failure locations. In the reset mode, a system reset is triggered to activate a process of overwriting and refreshing contents in the first memory, and the required address range in the reset mode is larger than a maximum range of the required address range of the partial refreshing mode and is smaller than, or as large as, the entire address space of the first memory 31. In this way, for the cache (the first memory 31) not having automatic content reread capabilities, based on the suitable error correction mode and the required address range thereof (overwriting and refreshing address range), contents in the cache can be overwritten and refreshed with correct contents in the NVM 2, achieving both high overwriting and updating efficiency and low time cost.

With combined reference to Figs. 4A and 4B, when the first memory 31 includes either or both of the cache 31b and the buffer 31a, the SLC module 32 is further configured for at least one of:
(1) when the first memory 31 includes both the cache 31b and the buffer 31a, determining which one of the cache 31b and the buffer 31a contains soft failure locations;
(2) if the soft failure locations are contained in the cache 31b, according to a required address range of a pre-configured error correction mode, or selecting a suitable error correction mode and configuring a required address range thereof according to the ECC error conditions and the soft failure locations, to invalidate contents in the required address range in the cache 31b, which contains the soft failure locations, wherein the invalidated associated address range is at least one cache line containing the soft failure locations, at least one cache set containing the soft failure locations, or the entire cache;
(3) if the soft failure locations are contained in the buffer 31a, firstly, selecting a suitable error correction mode according to the ECC error conditions and the soft failure locations and then copy correct contents in the required address range of the selected error correction mode from the NVM 2 into the buffer 31a to overwrite and refresh the soft failure locations in the first memory 31. In this case, error correction mode options may include a precise mode, a partial refreshing mode and a reset mode. In the precise mode, the required address range is the soft failure locations in the buffer 31a. In the partial refreshing mode, the required address range is at least one of: a wordline row containing at least the soft failure locations in the buffer, a bitline column containing at least the soft failure locations in the buffer; a sector containing at least the soft failure locations in the buffer; a page containing at least the soft failure locations in the buffer; a cluster containing at least the soft failure locations in the buffer; and a block containing at least the soft failure locations in the buffer, and wherein in the reset mode, a system reset is triggered to enable the overwriting and refreshing of contents in the buffer, and wherein the required address range of the reset mode is larger than a maximum range of the required address range in the partial refreshing mode and smaller than or as large as the entire buffer.

Optionally, the SLC module 32 may be further configured to, after the overwriting and refreshing of the first memory 31 is complete, cause the CPU 1 to reread the contents from the first memory 31 and cause the ECC logic module 30 to perform ECC on the reread contents. In this way, the system may be allowed to resume operation only when correctness of the updated contents has been confirmed, ensuring reliability of the system's subsequent operation.

It will be understood that the ECC logic module 30 and the SLC module 32 in the MC 3 of Embodiment 1 may be implemented with any suitable architecture design. In addition to the ECC logic module 30 and the SLC module 32 as discussed above, the MC 3 of Embodiment 1 may further include at least one of the buffer 31a and the cache 31b, as well as a bank of registers, which can temporarily store contents, addresses and other information to help the ECC logic module 30 and the SLC module 32 perform their intended functions.

For example, referring to Fig. 5, when the first memory 31 is or includes a cache, the SLC module 32 may further include a cache controller 32a with automatic reread capabilities, which is configured to invalidate contents in the cache according to a selected error correction mode. Moreover, when the CPU 1 or another master device unit fails to read the cache (more precisely, fails to read the invalidated address range required by the error correction mode) through the cache controller (i.e., a cache miss), the cache controller 32a may be further configured to automatically reread correct contents corresponding to the invalidated address range from the NVM 2 and replenish the reread contents into the cache to allow continued execution of a corresponding program. Therefore, with the cache controller 32a, even when a cache miss occurs, it is made possible automatically to still read desired contents from the cache.

For example, referring to Fig. 5, the MC 3 of Embodiment 1 may further include at least one of the following registers:
(1) an interrupt register 33, configured to generate, when a soft-failure induced ECC error occurs during ECC performed by the ECC logic module 30, an interrupt signal *int* to the CPU 1 to interrupt the CPU 1 (i.e., an ecc_error interrupt);
(2) an address record logic register 34, configured to record, in real time, an ECC error count, a bit error count and an address containing soft failure locations, depending on ECC conducted by the ECC logic module 30. It will be understood that the address record logic register 34 may include an accumulator (or counter) for recording the ECC error count, another accumulator (or counter) for recording a bit error count in each ECC error, and an address configuration register for storing an address containing soft failure locations (i.e., soft bit errors);
(3) an SLC enable register 35 configured to activate (or enable) the SLC module 32 when the bit error count in the address record logic register 34 exceeds the error correction ability of the ECC logic module 30;
(4) a mode select register 36 configured to pre-configure a suitable error correction mode, or select a suitable error correction mode for the SLC module 32 according to conditions of an ECC error obtained by the ECC logic module 30 and soft failure locations, to enable the SLC module 32 to handle soft failures in the first memory 31 by a corresponding error correction mode according to conditions of an ECC error and soft failure locations; and
(5) address configuration registers 37 configured for writing in the mode select register 36 of a required address range of an error correction mode selected by the mode select register 36 according to relevant information recorded in the address record logic register 34 and to the system's error correction need, in particular of start and end addresses of the required range in the first memory 31 that is overwritten and refreshed or invalidated. The address configuration registers 37 may include a start address configuration register (not shown) for storing the written start address and an end address configuration register (not shown) for storing the written end address.

With these registers, the MC 3 can perform the functions of ECC logic, ecc_error interrupts, ecc_error address record logic, SLC activation, recording of start and end addresses, error correction mode selection, etc.

Depending on required functionality, the registers may be only reset by a POR or similar operation.

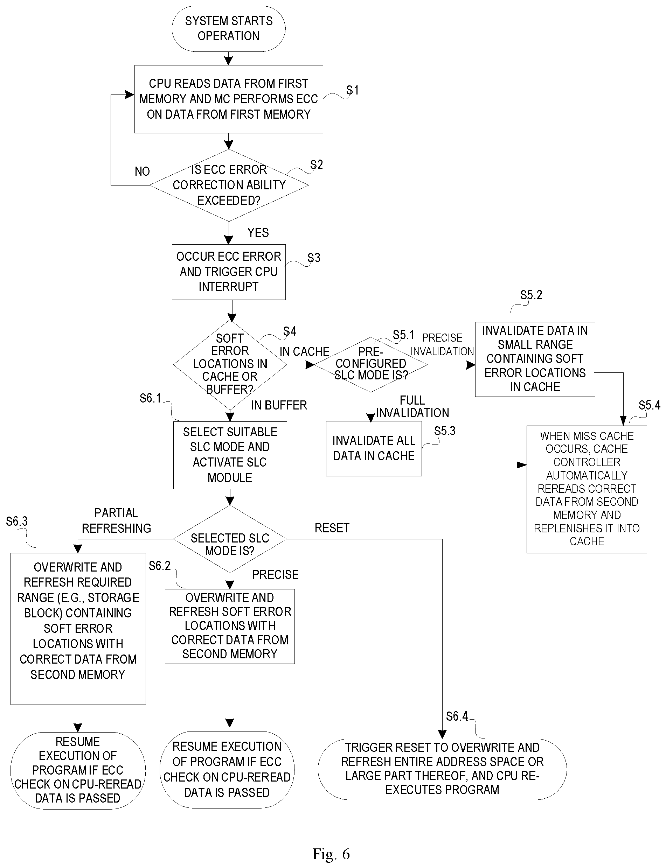

An example process of addressing soft failures in the first memory 31 by the MC 3 of Embodiment 1 will be described in detail below with reference to Figs. 4A to 4B and 6. In this example, the first memory 31 includes either or both of the buffer and the cache and the process includes the steps as follows:
In S1, the system starts operation, and the CPU 1 obtains contents in the NVM 2 necessary for operation of the system through reading backup contents from the first memory 31. During the reading of the first memory 31 by the CPU 1, the ECC logic module 30 in the MC 3 carries out real-time ECC on contents being read by the CPU 1 (from addresses in the first memory 31, which may be 32-bit, 64-bit, etc.) by checking whether corresponding ECC codes (7-bit, 8-bit, etc.) are correct or not in real time, to correct one or more (e.g., 1 or 2) bit errors and detect 2, 3 or more bit errors in the content ready by the CPU 1.

In S2, for each ECC result, the ECC logic module 30 determines in real time whether a bit error count exceeds the error correction ability of the ECC logic module 30.

A positive determination indicates that there are too many bit errors in the content read by the CPU 1 from the first memory 31 that the ECC logic module 30 cannot correct. When this happens, S3 is performed to confirm a soft-failure induced ECC error ecc_error and generate an interrupt signal *int* to the CPU 1, which triggers an interrupt of the CPU 1. In response, the CPU 1 stops executing the current program and starts executing an interrupt program.

In S4, the interrupt program obtains conditions of the ECC error and an address containing soft failure locations (by accessing the interrupt register 33, the address record logic register 34 and the like in the MC 3) and determines, based on an address range containing said address that contains the soft failure locations, which one of the buffer 31a and the cache 31b in the first memory 31 encountered the error. It will be understood that, in this step, regardless of whether the first memory 31 includes either or both of the buffer 31a and the cache 31b, the program can determine which one of the buffer 31a and the cache 31b contains the soft failure locations.

In step S4, if it is determined that the address range containing the soft failure locations is in the cache 31b, then the soft failures in the cache 31b are handled in a pre-configured error correction mode. For example, this may include one or more of the following sub-steps.

In S5.1, if the pre-configured error correction mode for the cache is an exact invalidation mode, then contents exactly in a required address range in the cache 31b, which contains the soft failure locations, may be invalidated (disabled). The required address range may consist of: a cacheline that contains the soft failure locations or multiple cachelines including the cacheline that contains the soft failure locations; or a cache set that contains the soft failure locations or multiple cache sets including the cache set that contains the soft failure locations; or a cache way that contains the soft failure locations or multiple cache ways including the cache way that contains the soft failure locations. Obviously, in this exact invalidation mode, only contents in the part of the address space of the cache 31b that contains the soft failure locations may be invalidated.

In S5.2, if the pre-configured error correction mode for the cache is a full invalidation mode, then the entire cache 31b, and hence all contents in the cache 31b, may be invalidated. In this case, contents containing errors that have been read by the CPU 1 from the cache may be subsequently discarded by software.

In S5.3, when the CPU 1 or another master device unit tries to reread said address (containing the soft failure locations) at a later time, a cache miss will occur in the cache 31b, and the cache controller 32a will automatically reread correct contents from the NVM 2 and replenished into the cache 31b, allowing the interrupted program to resume execution after a short time.

In Embodiment 1, the error correction mode for the cache is pre-configured, and it is impossible to flexibly select a suitable error correction mode for the cache 31b according to the ECC error conditions. However, the present invention is not so limited. In other embodiments of the present invention, a corresponding mode select register may be provided to the cache 31b, which is able to select, according to the ECC error conditions, a suitable error correction mode for addressing the soft failures in the cache 31b. In these cases, only contents in an appropriate, reasonable address range in the cache 31b, which contains the soft failure locations, are invalidated, circumventing the invalidation of all contents in the cache 31b in the pre-configured full invalidation mode, which would require a longer handling time of the system. Further, the full invalidation mode in S5.2 may be only triggered only when the accumulated ECC error count exceeds a preset threshold.

In step S4, if it is determined that the address range containing the soft failure locations is in the buffer 31a, then S6.1 is performed to select, based on the ECC error count, the bit error count and the like, as well as on the address range containing the soft failure locations, a suitable error correction mode (SLC mode), and if required, record an address range of the error correction mode (i.e., start and end addresses thereof). After that, the SLC module 32 is activated to handle the soft failures in the buffer 31a. Note that, in this case, the MC 3 is not able to automatically reread correct contents from the NVM 2 for the buffer 31a like the cache controller 32a, the interrupt program is required to activate the SLC module 32 to perform one of the following three tasks.
(1) If the selected SLC mode is a precise mode, then S6.2 is performed, in which the SLC module 32 copies only contents at the address containing the soft failure locations (error contents) from the NVM 2 into the buffer 31a. That is, the error contents at the address containing the soft failure locations in the buffer 31a are overwritten and refreshed with corresponding correct contents. After the copying process is completed, the CPU 1 reads back the updated contents at the soft failure locations, and the ECC logic module 30 performs another ECC process on the updated contents. If no soft-failure induced ECC error occurs, the CPU 1 resumes the exertion of the interrupted program. For example, the address containing the soft failure locations (i.e., containing the errors) identified in the ECC process by the ECC logic module 30 has been reported as Byte0. Assuming that the buffer 31a has a physical bit-width of 32 bits, since a physical address in the buffer corresponds to a logical address divided by 4, the error contents at the soft failure locations correspond to Byte0-Byte3. Therefore, in the precise mode, contents at Byte0-Byte3 are copied from the NVM 2 for correcting the errors. This precise mode for the buffer requires minimal overhead in time.
(2) If the selected SLC mode is a partial refreshing mode, then S6.3 is performed, in which the SLC module 32 copies contents in the address range from the start address to the end address recorded in step S6.1 (i.e., the required address range of the selected error correction mode, which contains the soft failure locations) from the NVM 2 into the buffer 31a. That is, the buffer 31a is overwritten and refreshed with corresponding correct contents. After the copying process is completed, the CPU 1 reads back the updated contents at the soft failure locations, and the ECC logic module 30 performs another ECC process on the updated contents. If no soft-failure induced ECC error occurs, the CPU 1 resumes the exertion of the interrupted program. In this way, in the event of soft failures occurring in the buffer 31a, contents at exact locations, in a small range, in a large range or in the entire address space may be overwritten and refreshed depending on the actual circumstances and need. Conventionally, regardless of conditions of such soft failures, all contents in the entire buffer 31a would have to be overwritten, leading to significant time consumption.

The partial refreshing mode may be row-wise (wordline-wise), column-wise (bitline-wise), page-wise, sector-wise, block-wise, cluster-wise, etc. The required address range of the partial refreshing mode, which is overwritten and refreshed, is larger than an address range consisting of the soft failure locations and smaller than the entire address space of the buffer. **In** the wordline-wise mode, the required address range may be one wordline row that contains the soft failure locations, or multiple wordline rows that contains the soft failure locations and at least one adjacent wordline row. **In** the bitline-wise mode, the required address range may be one bitline column that contains the soft failure locations, or multiple bitline columns that contains the soft failure locations and at least one adjacent bitline column. **In** the page-wise mode, the required address range may be one page that contains the soft failure locations, or multiple pages that contains the soft failure locations and at least one adjacent page. In the sector-wise mode, the required address range may be one sector that contains the soft failure locations, or multiple sectors that contains the soft failure locations and at least one adjacent sector. In the block-wise mode, the required address range may be one block that contains the soft failure locations, or multiple blocks that contains the soft failure locations and at least one adjacent block. In the cluster-wise mode, the required address range may be one cluster that contains the soft failure locations, or multiple blocks that contains the soft failure locations and at least one adjacent cluster. In the first memory, each page may consist of multiple wordline rows or bitline columns, each sector may consist of multiple pages, each block may consist of multiple sectors, and each cluster may consist of multiple blocks.

Despite moderate time overhead, this partial refreshing mode requires a larger range in the buffer to be overwritten and refreshed than the precise mode. When one or more of the soft failure locations are around the reported address in the ECC process by the ECC logic module 30, this can effectively update and correct contents in the buffer that contain such errors. For example, assume that the buffer 31a has a physical bit-width of 32 bits. Therefore, a physical address in the buffer corresponds to a logical address divided by 4. Moreover, assume that, although the address containing the soft failure locations (i.e., containing the errors) identified in the ECC process by the ECC logic module 30 has been reported as Byte0, one or more of the soft failure locations may be at Byte5 or Byte7 (which is around Byte0 and therefore associated with a higher soft-failure probability). In this case, the partial refreshing mode may be a block-wise mode, in which Byte0-Byte7 are all overwritten and updated. Thus, contents containing all the soft failure locations can be simultaneously corrected.

(3) If the selected SLC mode is a reset mode, then S6.4 is performed, in which contents at logical addresses in the NVM 2 corresponding to the entire address space of the buffer (a full reset mode), or part thereof (a partial reset mode), are copied. Subsequently, a system reset is triggered by software to cause the CPU 1 to take corresponding actions. In case of this reset mode, it is actually not necessary to activate the SLC function by software in step S6.1. In other words, the SLC function is activated as a result of being triggered by a system reset. Moreover, when the partial reset mode is selected, although the overwritten address range in the buffer 31a similarly spans from the recorded start address to the recorded end address, this address range is instead larger than a maximum range of the required address range of the partial refreshing mode and smaller than the address space of the buffer 31a. After the reset is released and the copying process is completed, the CPU 1 re-executes from the starting point of the buffer 31a. As this reset mode is typically most time-consuming and involves interrupting operation of the system by a reset, it should be used only when the accumulated bit error count or ecc_error count exceeds a preset threshold and contents in the buffer 31a are accordingly considered to have been extensively tampered or damaged. The overwritten range in this reset mode is the largest, or even allows all contents in the buffer 31a to be updated. Further, the CPU 1 re-executes software programs, and all previous errors are eliminated due to the reset.

Therefore, according to Embodiment 1, when soft failures occur in a cache, some or all contents in the cache can be exactly and reasonably invalidated in a pre-configured error correction mode. When soft failures occur in the buffer 31a, a suitable error correction mode can be selected, in which contents at exact locations, in an address range or in the entire address space of the buffer 31a can be overwritten and refreshed with correct contents from the NVM 2, depending on the actual circumstances. In addition, only when contents in the cache or buffer are extensively tampered or damaged, full invalidation mode or reset mode will be used. Conventionally, once there occur too many bit errors in a buffer or cache, which exceed the error correction ability of an ECC module, a large amount of correct content would have to be re-copied to overwrite and refresh the buffer, or all contents in the cache would have to be invalidated, leading to significant time consumption. **In** contrast, according to Embodiment 1, this problem is circumvented by taking into account overwriting and refreshing efficiency, as well as time overhead and cost.

Referring to Figs. 3 to 6, in Embodiment 1, there is also provided an MCU chip including, a CPU 1, first memory 31 and the MC 3 of Embodiment 1, which are integrated in a single chip package. Additionally, second memory (NVM) 2 is provided inside or outside the MCU chip and connected to the MC 3. The first memory 31 is associated with a higher soft-failure probability than the NVM 2. The NVM 2 is main memory, and the first memory 31 may be a cache for backing up at least a part of contents in the NVM 2 under the control of the MC 3. The CPU 1 is at least configured to read desired contents from the first memory 31. The MC 3 is configured to control read operations of the CPU 1 on the first memory 31 and the NVM 2. During reading of the first memory 31, the MC 3 is also configured to perform ECC on contents read from the first memory 31, achieving real-time detection and correction of errors in the first memory 31. When there are errors exceeding the error correction ability of the ECC function, a soft-failure induced ECC error occurs, and a suitable error correction mode is responsively selected from different error correction modes in adaptation to conditions of the ECC error and soft failure locations to handle the soft failures in the first memory 31.

Since the MCU chip of Embodiment 1 incorporates the MC of the present invention, when the CPU 1 needs to read desired contents from the NVM 2, it can read corresponding backup contents from the first memory 31 according to an address mapping under the control of the MC, and can perform ECC on the read contents. When too many soft failures occur, which cannot be corrected by the ECC process, it can accurately identify the locations of the soft failures (i.e., an address containing the errors), and if required, can invalidate data in a suitable address range in the first memory, which contains the soft failure locations, or rapidly overwrite and refresh the data with correct data, in contrast to the prior art, in which once the error correction ability of the ECC function is exceeded, all contents in the first memory must be overwritten or invalidated, leading to a waste of time. Thus, in addition to assured high reliability, rapid error correction can be achieved, and the CPU can resume operation after a short interrupt.

### Embodiment 2

The present invention is not only applicable to solving the soft failure issue in the first memory 31 when the first memory 31 is a cache and NVM2 is a main memory, but it can also address the soft failure issue in the first memory 31 when the first memory 31 is a main memory while NVM2 is used to back up at least a part of the content from the main memory.

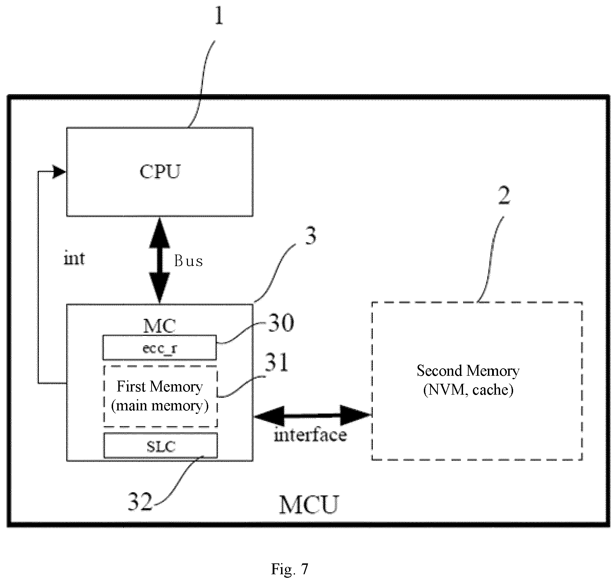

Accordingly, referring to Fig. 7, in a second embodiment of the present invention, there is provided a memory controller (MC) 3 also coupled to a central processing unit (CPU) 1, first memory 31 and non-volatile memory (NVM) 2. Differing from the first embodiment, the first memory 31 is main memory and the NVM 2 is configured to back up at least a part of contents in the main memory in Embodiment 2. The MC 3 is configured to control operations of the CPU 1 on the first memory 31 and the NVM 2. The first memory 31 is read and written faster, and associated with a higher soft-failure probability, than the NVM 2.

In Embodiment 2, in order to read data from the first memory 31, the CPU converts logical addresses into actual physical addresses in the first memory 31. As a backup of the first memory 31, actual physical addresses in the NVM 2 are mapped to actual physical addresses in the first memory 31. In the event of soft failures occurring in the first memory 31, the MC 3 can read corresponding backup contents from the NVM 2 according to the address mapping, to overwrite and refresh contents in a corresponding address range in the first memory 31.

Similarly to the first embodiment, the NVM 2 may be either on-chip memory, or off-chip memory, and accordingly no further description is necessary. The NVM 2 has a large storage capacity. While contents in the first memory 31 are being backed up to the NVM 2, error checking and correction (ECC) codes of the backup contents may be stored in either or both of the NVM 2 and the first memory 31, which provides a basis for ECC in read operations. As an example, the NVM 2 may include at least one of flash memory and dynamic random-access memory (DRAM).

The first memory 31 may include at least one of ferroelectric random-access memory (FRAM), resistive random-access memory (RRAM), magnetoresistive random-access memory (MRAM) and phase-change random-access memory (PRAM). It is on-chip memory and may be formed in the MCU chip using embedded memory technology. Moreover, the first memory 31 is read and written faster than the NVM 2.

MRAM cells are magnetic tunnel junctions (MTJs), which, when magnetized in different directions, exhibit different magnetoresistances to represent 0 and 1. As long as the magnetic field does not change, the magnetic tunnel junctions will each remain magnetized in a fixed direction. MRAM has the advantages of fast reading and writing at a speed almost 1,000 times than a speed of flash memory, high integration and an almost infinite number of times of repeated writing.

PRAM utilizes differences in conductivity exhibited by a phase-change material in transitions between its crystalline and amorphous states to store contents. Theoretically, PRAM is read and written almost 1,000 times faster than flash memory.

RRAM stores contents by taking advantage of the dependence of a memositor's resistance on a current that is flowing therethrough. Like SRAM, RRAM can be directly programmed, differing from flash memory that must be erased before it can be programmed.

FRAM utilizes the ferroelectricity of ferroelectric crystals to store contents. Ferroelectricity is a property of a ferroelectric crystal that a central atom in the crystal moves in a stable pattern when an electric field is applied thereto. After the electric field is removed from the crystal, the center atom will remain at the original position. This is because a central layer of the crystal creates a high energy barrier, and the center atom is not able to cross over the energy barrier to another stable position without external energy. Therefore, FRAM can maintain contents stored therein without being supplied with a voltage, or periodically refreshed like DRAM. As ferroelectricity is an inherent polarization characteristic of ferroelectric crystals, which has nothing to do with electromagnetic effects, contents stored in FRAM will not be affected by environmental factors, such as magnetic fields. Thus, FRAM can be used just like normal ROM and has non-volatile storage characteristics. FRAM is characterized by a fast speed and in operating like RAM and being read and written with extremely low power consumption, but is associated with an upper limit of the number of times of access (reading).

As an example, the first memory 31 is RRAM, and NVM 2 is system-in-package (SiP) flash memory.

Referring to Fig. 7, in Embodiment 2, the MC 3 also includes an ECC logic module 30 and an SLC module 32.

The ECC logic module 30 may be implemented by any suitable architecture design known in the art and is configured to, during reading of contents by the CPU 1 from the first memory 31 (i.e., the main memory implemented, for example, as RRAM), perform ECC on the contents in the first memory 31, thereby achieving real-time error detection and correction of the contents in the first memory 31. If there are too many errors exceeding the error correction ability of the ECC logic module 30, a soft-failure induced ECC error occurs.

In Embodiment 2, in response to a power-on reset (POR) or system reset, the SLC module 32 in the MC 3 can back up (or copy) contents in the first memory 31 (i.e., the main memory implemented, for example, as RRAM) to the NVM 2 (e.g., a cache). During the backup process, the ECC logic module 30 may generate one (i.e., 1-bit) or more (e.g., 2-bit, 3-bit, etc.) check bits as an ECC code (or checksum) for each copied segment of content according to a specific encoding rule, the ECC code is then stored, together with the corresponding backup content segment, at a corresponding address in the NVM 2, or at a corresponding address in the first memory 31, or at both. The locations of the check bits are carefully selected to allow one or more identified bit errors in the first memory 31 to be located and corrected. Therefore, the ECC codes can be used not only to detect an error, but also to indicate the specific location of the error. Thus, when CPU 1 reads the content from the first storage 31, it provides the basis for the ECC logic module 30 to perform ECC checks and corrections on the read content from the first storage.

The SLC module 32 is configured to select, based on conditions of an ECC error obtained by the ECC logic module 31 and on soft failure locations, a suitable error correction mode for handling the soft failures in the first memory 31 from various available error correction modes. Such handling may include overwriting and refresh the soft failure locations in the first memory 31.

In the selected error correction mode (i.e., an SLC mode), the SLC module 32 copies backup contents (considered as correct contents) in the required address range for the selected mode in the NVM 2 into the first memory 31, to overwrite and refresh the first memory 31. The required address ranges for different error correction modes vary in size, which may range from the address of the soft failure location to the entire address space of the first memory 31.

Optionally, the required address ranges of the error correction modes may have pre-configured sizes, or may have sizes temporarily configured in adaptation to the actual circumstances. For example, for any selected error correction mode, the required address range may be temporarily configured on the basis of the actual circumstances by providing address configuration registers for recording start and end addresses of the range.

**In** Embodiment 2, error correction mode options may include, for example, a precise mode, a partial refreshing mode and a reset mode. **In** the precise mode, the required address range consists of only the soft failure locations in the first memory 31. **In** the partial refreshing mode, the required address range has a size, which is fixed or configured in adaptation to the ECC error conditions and the soft failure locations. The partial refreshing mode may be a wordline-wise mode (in which the required address range consists of at least one wordline row in the first memory 31, which contains the soft failure locations), a bitline-wise mode (in which the required address range consists of at least one bitline column in the first memory 31, which contains the soft failure locations), a sector-wise mode (in which the required address range consists of at least one sector in the first memory 31, which contains the soft failure locations), a page-wise mode (in which the associated address range consists of at least one page in the first memory 31, which contains the soft failure locations), a block-wise mode (in which the associated address range consists of at least one block in the first memory 31, which contains the soft failure locations), or a cluster-wise mode (in which the associated address range consists of at least one cluster in the first memory 31, which contains the soft failure locations). In the reset mode, a system reset is triggered to activate a process of overwriting and refreshing contents in the first memory 31, and the required address range is larger than a maximum of the required address range of the partial refreshing mode and is smaller than, or as large as, the entire address space of the first memory 31. In this way, in various soft failure situations, soft failures can be rapidly corrected, improving the system's operational continuity, ensuring its high operational reliability and addresses various reliability needs. In the first memory 31, each page may consist of multiple wordline rows or bitline columns, each sector may consist of multiple pages, each block may consist of multiple sectors, and each cluster may consist of multiple blocks.

In other words, in Embodiment 2, when there are too many soft failures in contents in the first memory 31 that the ECC logic module 30 is not able to correct, the SLC module 32 may select a suitable error correction mode according to the error situation, in which error contents in the required address range in the first memory 31 are overwritten and updated with backup data from the NVM 2, thereby addressing the soft failures in the first memory 31. This can circumvent updating all contents in the first memory 31 by a reset in any soft failure situation, which may lead to significant time consumption. In this way, operating continuity of the system can be ensured, and various reliability needs can be addressed.

Optionally, in Embodiment 2, the SLC module 32 may be further configured to, after the overwriting and refreshing of the first memory 31 is complete, cause the CPU 1 to reread the contents from the first memory 31 and cause the ECC logic module 30 to perform ECC on the reread contents. In this way, the system may be allowed to resume operation only when correctness of the updated contents has been confirmed, ensuring reliability of the system's subsequent operation.

It will be understood that the ECC logic module 30 and the SLC module 32 in the MC 3 of this embodiment may be implemented by any suitable architecture design. In addition to the ECC logic module 30 and the SLC module 32 as discussed above, the MC 3 of Embodiment 2 may further include a bank of registers, which can temporarily store contents, addresses and other information to help the ECC logic module 30 and the SLC module 32 perform their intended functions.

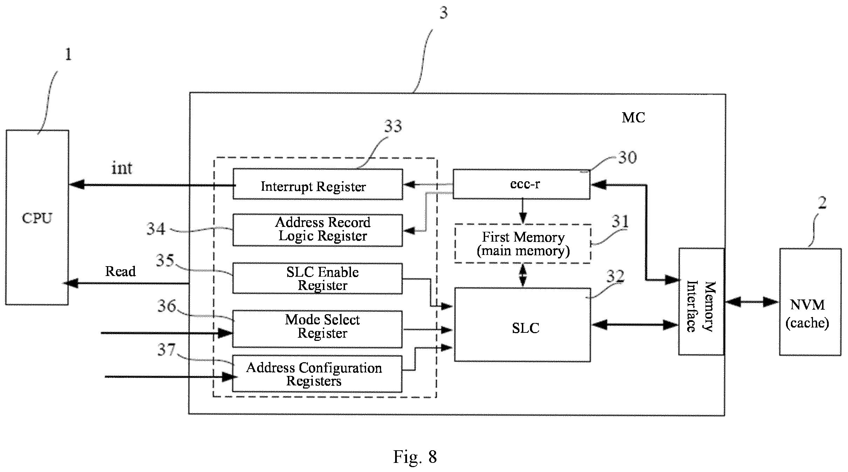

For example, referring to Fig. 8, the MC 3 of Embodiment 3 may further include at least one of an interrupt register 33, an address record logic register 34, an SLC enable register 35, a mode select register 36 and address configuration registers 37. The interrupt register 33, the address record logic register 34, the SLC enable register 35, the mode select register 36 and the address configuration registers 37 may function substantially in the same way as those of first embodiment and, therefore, need not be described in further detail herein. With these registers, the MC 3 can perform the functions of ECC logic, ecc_error interrupts, ecc_error address record logic, SLC activation, recording of start and end addresses, error correction mode selection, etc. Depending on required functionality, the registers may be only reset by a POR or similar operation.

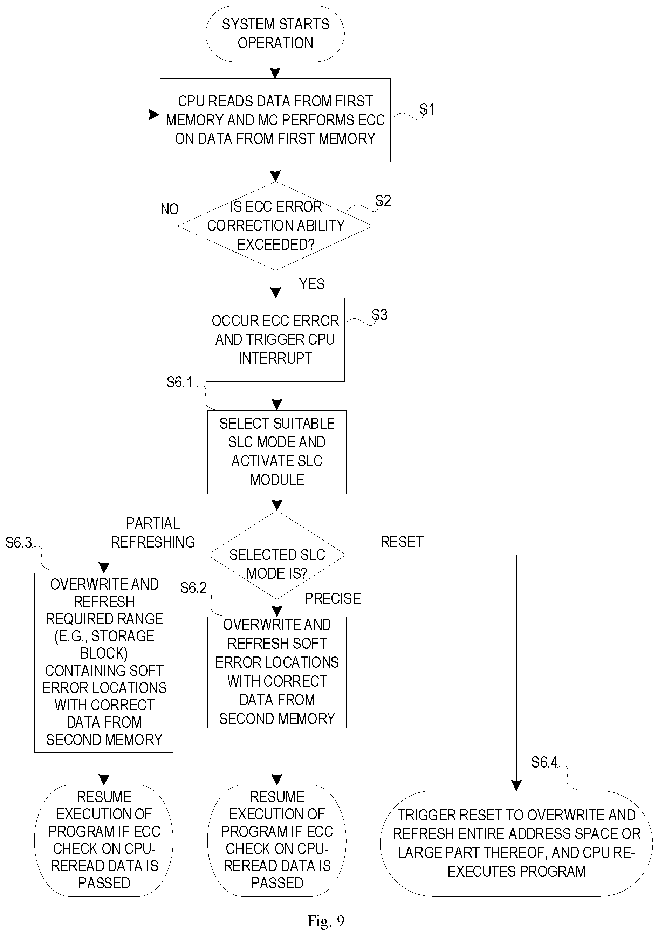

Fig. 9 shows a flowchart of a process of addressing soft failures in the first memory 31 by the memory controller (MC) of Embodiment 2. Steps in this process comprises S1 to S3 and S6.1 to S6.4 in the process of Fig. 6 according to the first embodiment, and are therefore given the same reference numerals. Specifically, this process includes the following steps.

In S1, the system starts operation, and the CPU 1 reads contents from the first memory 31 (i.e., the main memory). During the reading of the first memory 31 by the CPU 1, the ECC logic module 30 in the MC 3 carries out real-time ECC on contents being read by the CPU 1 (from addresses in the first memory 31), for example, by checking whether corresponding ECC codes are correct or not in real time, to correct one or more (e.g., 1 or 2) bit errors and detect 2, 3 or more bit errors in the content read by CPU 1.

In S2, for each ECC result, the ECC logic module 30 determines in real time whether a bit error count exceeds the error correction ability of the ECC logic module 30.

A positive determination indicates that there are too many bit errors in the content read by the CPU 1 from the first memory 31 that the ECC logic module 30 cannot correct. When this happens, S3 is performed to confirm a soft-failure induced ECC error ecc_error and generate an interrupt signal *int* to the CPU 1, which triggers an interrupt of the CPU 1. In response, the CPU 1 stops executing the current program and starts executing an interrupt program.

In S6.1, the interrupt program obtains conditions of the ECC error (the recorded current ECC error count, bit error count, etc.) and an address range containing soft failure locations (by accessing the interrupt register 33, the address record logic register 34 and the like in the MC 3) and selects, based on the ECC error count, the bit error count and the like, as well as on the address range of the soft failure locations, a suitable error correction mode (SLC mode). Moreover, if required, it records a required address range of the error correction mode (i.e., start and end addresses thereof). After that, the SLC module 32 is activated to handle the soft failures in the first memory 31 by performing one of the following three tasks.
(1) If the selected SLC mode is a precise mode, then S6.2 is performed, in which the SLC module 32 copies only contents at the address of the soft failure locations (error contents) from the NVM 2 into the first memory 31. That is, the error contents at the address of the soft failure locations in the first memory 31 are overwritten and refreshed with corresponding correct contents. After the copying process is completed, the CPU 1 reads back the updated contents at the soft failure locations, and the ECC logic module 30 performs another ECC process on the updated contents. If no soft-failure induced ECC error occurs, the CPU 1 resumes the exertion of the interrupted program. This precise mode requires minimal overhead in time.
(2) If the selected SLC mode is a partial refreshing mode, then S6.3 is performed, in which the SLC module 32 copies backup contents in the address range from the start address to the end address recorded in step S6.1 (i.e., a required address range of the selected error correction mode, which contains the address of the soft failure locations) from the NVM 2 into the first memory 31. That is, the error contents in the first memory 31 are overwritten and refreshed with correct backup contents in the required address range of the selected error correction mode. After the copying process is completed, the CPU 1 reads back the updated contents at the soft failure locations, and the ECC logic module 30 performs another ECC process on the updated contents. If no soft-failure induced ECC error occurs, the CPU 1 resumes the exertion of the interrupted program. This partial refreshing mode may be the above-described wordline-wise mode, bitline-wise mode, page-wise mode, sector-wise mode, block-wise mode, cluster-wise mode, etc.
(3) If the selected SLC mode is a reset mode, then S6.4 is performed, in which all backup contents in the NVM 2, or backup contents corresponding to the address ranges from the recorded start address to end address, are copied into the first memory 31. Subsequently, a system reset is triggered by software to cause the CPU 1 to take corresponding actions. After the reset is released and the copying process is completed, the CPU 1 re-executes from the starting point of the first memory 31. As this reset mode is typically most time-consuming and involves interrupting operation of the system by a reset, it should be used only when the accumulated bit error count or ecc_error count exceeds a preset threshold.

Referring to Figs. 7 to 9, in Embodiment 2, there is also provided an MCU chip including a CPU 1, first memory 31 and the MC 3 of Embodiment 2, which are integrated in a single chip package. Additionally, second memory (NVM) 2 is provided inside or outside the MCU chip and connected to the MC 3. The first memory 31 is associated with a higher soft-failure probability than the NVM 2. The first memory 31 is main memory, and the NVM 2 is configured to back up at least a part of contents in the first memory 31 under the control of the MC 3. The CPU 1 is at least configured to read desired contents from the first memory 31. The MC 3 is configured to control read operations of the CPU 1 on the first memory 31 and the NVM 2. During reading of the first memory 31, the MC 3 is also configured to perform ECC on contents read from the first memory 31, achieving real-time detection and correction of errors in the first memory 31. When there are errors exceeding the error correction ability of the ECC function, a soft-failure induced ECC error occurs, and a suitable error correction mode is responsively selected from different error correction modes in adaptation to conditions of the ECC error and soft failure locations to handle the soft failures in the first memory 31.

The description presented above is merely that of some preferred embodiments of the present invention and does not limit the scope thereof in any sense. Any and all changes and modifications made by those of ordinary skill in the art based on the above teachings fall within the scope as defined in the appended claims.

## Claims

1. A memory controller (3), coupled to a central processing unit (CPU) (1), a first memory (31) and a second memory (2), the first memory (31) being associated with a higher soft-failure probability than the second memory (2), one of the first memory (31) and the second memory (2) being a main memory and the other one of the first memory (31) and the second memory (2) being configured to back up at least a part of contents in the main memory, wherein the memory controller (3) comprises:
an error checking and correction (ECC) logic module (30), configured to, during reading of contents by the CPU (1) from the first memory (31), perform an ECC on the contents from the first memory (31) to detect and correct error contents from the first memory (31) in real time, wherein in case of errors exceeding an error correction ability, a soft-failure induced ECC error occurs; and
a smart load controller (SLC) module (32), configured to select different error correction modes for handling the soft failures in the first memory (31) based on conditions of different ECC errors obtained by the ECC logic module (30) and soft failure locations, wherein the handling comprises overwriting and refreshing or invalidating the soft failure locations in the first memory (31),
wherein a required address range of different error correction modes varies in size.

2. The memory controller (3) of claim 1, wherein a minimum range of the required address range is an address of the soft failure location, and wherein a maximum range of the required address range is an entire address space of the first memory (31).

3. The memory controller (31) of claim 1, wherein the SLC module (32) is further configured to copy correct contents in the required address range of the selected error correction mode from the second memory (2) into the first memory (31), to accomplish the overwriting and refreshing of the first memory (31).

4. The memory controller (3) of claim 1, wherein the memory controller (3), the first memory (31) and the CPU (1) are integrated in a single chip, wherein the first memory (31) is an on-chip memory of the chip, and wherein the second memory (2) is non-volatile and is an on-chip memory or an off-chip memory of the chip.

5. The memory controller (3) of claim 4, wherein the second memory (2) is the main memory and the first memory (31) is a cache that is read and written faster than the second memory (2), wherein the SLC module (32) is further configured for at least one of:
(1) upon a power-on reset (POR) or a system reset, or when the CPU (1) reads the first memory (31) and a cache miss occurs, backing up corresponding contents in the second memory (2) to the first memory (31) and storing an ECC code corresponding to the backup contents in the first memory (31), wherein when the CPU (1) is reading corresponding contents in the first memory (31), the ECC logic module (30) performs an ECC on the contents read from the first memory (31) by checking whether the ECC code is correct or not;
(2) when the first memory (31) with automatic content reread capabilities, selecting a corresponding error correction mode and configuring the required address range of the corresponding error correction mode based on: a pre-configured error correction mode and the required address range thereof; or conditions of the ECC error and the soft failure locations, to invalidate contents in the required address range in the first memory (31) based on the selected error correction mode, wherein the required address range contains the soft failure locations;
(3) when the first memory (31) without automatic content reread capabilities, selecting a suitable error correction mode, based on conditions of the ECC error and the soft failure locations, to copy correct contents in the required address range of the selected error correction mode from the second memory (2) into the first memory (31), thereby overwriting and refreshing the soft failure locations in the first memory (31), wherein the error correction modes comprises a precise mode, a partial refreshing mode and a reset mode, wherein in the precise mode, the required address range is the soft failure locations in the first memory (31), wherein in the partial refreshing mode, the required address range is fixed, or configured in adaptation to the conditions of the ECC error and the soft failure locations, wherein in the reset mode, a system reset is triggered to enable the overwriting and refreshing of contents in the first memory (31), and wherein in the reset mode, the required address range is larger than a maximum range of the required address range in the partial refreshing mode and smaller than or as large as an entire address space of the first memory (31).

6. The memory controller (3) of claim 5, wherein the first memory (31) is a static random-access memory (SRAM), preferably wherein the first memory (31) is an SRAM buffer or an SRAM cache for backing up at least a part of contents in the second memory (2), or wherein the first memory (31) comprising: a buffer (31a) for backing up a part of contents in the main memory; and a cache (31b) for backing up contents outside an address range of the buffer (31a).

7. The memory controller (3) of claim 6, wherein the SLC module (32) is further configured for at least one of:
(1) in case of the first memory (31) comprising the cache (31b) and the buffer (31a), firstly determining which one of the cache (31b) and the buffer (31a) contains the soft failure locations;
(2) in case of the soft failure locations being in the cache (31b), selecting a suitable error correction mode and configuring the required address range of the error correction mode based on: a pre-configured error correction mode and the required address range thereof; or conditions of the ECC error and the soft failure locations, to invalidate contents in the required address range in the cache (31b), wherein the required address range contains the soft failure locations, and wherein the invalidated required address range is: at least one cache line containing the soft failure locations; or at least one cache set containing the soft failure locations; or at least one cache way containing the soft failure locations; or an entire cache (31b);
(3) in case of the soft failure locations being in the buffer (31a), selecting a suitable error correction mode based on the conditions of the ECC error and the soft failure locations, to copy correct contents in the required address range of the selected error correction mode from the second memory (2) into the buffer (31a), thereby overwriting and refreshing the soft failure locations in the buffer (31a), wherein the selected error correction modes comprises a precise mode, a partial refreshing mode and a reset mode, wherein in the precise mode, the required address range is the soft failure locations in the buffer (31a), wherein in the partial refreshing mode, the required address range is at least one of: a row in the buffer (31a), that contains at least the soft failure locations, a column in the buffer (31a), that contains at least the soft failure locations; a sector in the buffer (31a), that contains at least the soft failure locations; a page in the buffer (31a), that contains at least the soft failure locations; a cluster in the buffer (31a), that contains at least the soft failure locations; and a block in the buffer (31a), that contains at least the soft failure locations, and wherein in the reset mode, a system reset is triggered to enable the overwriting and refreshing of contents in the buffer (31a), and wherein the required address range of the reset mode is larger than a maximum range of the required address range in the partial refreshing mode and smaller than or as large as an entire buffer (31a).

8. The memory controller (3) of claim 7, wherein when the memory controller (3) is coupled to the cache (31b), the SLC module (32) further comprises a cache controller (32a), wherein the cache controller (32a) is configured to accomplish the invalidation of corresponding contents in the cache (31b), and wherein when the CPU (1) or other master device unit reads the cache (31b) through the cache controller (32a) and a cache miss occurs, the cache controller (3) is configured to automatically reread corresponding correct contents from the second memory (2) and replenishing the correct contents into the cache (31b).

9. The memory controller (3) of claim 4, wherein the first memory (31) is the main memory and is non-volatile and the second memory (2) is configured to back up at least a part of contents in the main memory, wherein the first memory (31) is read and written faster than the second memory (2), and wherein the SLC module (32) is further configured for at least one of:
(1) upon a POR or a system reset, backing up contents in the first memory (31) to the second memory (2) and storing an ECC code corresponding to the backup contents in the second memory (2) and/or the first memory (31), wherein when the CPU (1) is reading corresponding contents in the first memory (31), the ECC logic module (30) is configured to perform the ECC on the contents read from the first memory (31) by checking whether the corresponding ECC code is correct or not;
(2) selecting a suitable error correction mode, based on conditions of the ECC error and the soft failure locations, to copy correct contents in the required address range of the selected error correction mode from the second memory (2) into the first memory (31), thereby overwriting and refreshing the soft failure locations in the first memory (31), wherein the error correction modes comprises a precise mode, a partial refreshing mode and a reset mode, wherein in the precise mode, the required address range is the soft failure locations in the first memory (31), wherein in the partial refreshing mode, the required address range is fixed or configured in adaptation to the conditions of the ECC error and the soft failure locations, wherein in the reset mode, a system reset is triggered to enable the overwriting and refreshing of contents in the first memory (31), and wherein the required address range of the reset mode is larger than a maximum range of the required address range in the partial refreshing mode and smaller than or as large as an entire address space of the first memory (31).

10. The memory controller (3) of claim 9, wherein the first memory (31) comprises at least one of ferroelectric random-access memory (FRAM), resistive random-access memory (RRAM), magnetoresistive random-access memory (MRAM) and phase-change random-access memory (PRAM).

11. The memory controller (3) of claim 5 or 7 or 9, wherein the SLC module (32) is further configured to determine whether an accumulated ECC error count and/or a bit error count exceeds a preset threshold and, if so, the reset mode is selected, or otherwise the precise mode or the partial refreshing mode is selected.

12. The memory controller (3) of claim 5 or 7 or 9, wherein the SLC module (32) is further configured, when the selected error correction mode is the reset mode or the partial refreshing mode, to configure the required address range of the selected error correction mode by configuring a start address and an end address of an address range of the first memory (31) to be overwritten and refreshed based on requirements.

13. The memory controller (3) of claim 1, wherein the SLC module (32) is further configured to, after the overwriting and refreshing of the first memory (31) is completed, cause the CPU (1) to reread corresponding contents from the first memory (31) and to cause the ECC logic module (30) to perform the ECC on the contents reread by the CPU (1).

14. The memory controller (3) of any one of claims 1 to 10 or 13, further comprising at least one of:
an interrupt register (33), configured to interrupt the CPU (1) in response to an occurrence of a soft-failure induced ECC error;
an address record logic register (34), configured to record an ECC error count, a bit error count and addresses of the soft failure locations in real time depending on an ECC conducted by the ECC logic module (30);
an SLC enable register (35), configured to activate the SLC module (32) once the bit error count in the address record logic register (34) exceeds the error correction ability of the ECC logic module (30);
a mode select register (36), configured to pre-configure or pre-select a suitable error correction mode for the SLC module (32) based on conditions of different ECC errors and the soft failure locations, such that the SLC module (32) handles the soft failures in the first memory (31) using corresponding error correction mode according to conditions of the ECC error and the soft failure locations; and
an address configuration register (37), configured for writing therein of a start address and an end address of the first memory (31) that are to be overwritten and refreshed or invalidated in the error correction mode based on relevant information recorded in the address record logic register (34) and a system need for error correction.

15. A microcontroller unit (MCU) chip comprising: a central processing unit (CPU) (1), a first memory (31) and the memory controller (3) of any one of claims 1 to 14, that are integrated in a single chip package, wherein a second memory (2) is disposed inside or outside the MCU chip and is coupled to the memory controller (3),
wherein the first memory (31) is associated with a higher soft-failure probability than the second memory (2), wherein one of the first memory (31) and the second memory (2) is a main memory and the other one of the first memory (31) and the second memory (2) is configured to back up at least a part of contents in the main memory under control of the memory controller (3),
the CPU configured at least to read corresponding contents from the first memory (31),
wherein the memory controller (3) is configured to: control read operations of the CPU (1) on the first memory (31) and the second memory (2); during reading of contents from the first memory (31), perform an error checking and correction (ECC) on corresponding contents from the first memory (31) to detect and correct of error contents from the first memory (31) in real time; when the errors exceeds an error correction ability, generate a soft-failure induced ECC error; and select a corresponding error correction mode for handling the soft failures in the first memory (31) in adaption to conditions of different ECC errors and the soft failure locations.
